# EUROPEAN PATENT APPLICATION

(11) **EP 2 339 635 A2**
(43) Date of publication of application: **29.06.2011**
(21) Application number: 10196754.5
(22) Date of filing: 23.12.2010
(51) Int. Cl.: H01L 29/778, H01L 29/06, H01L 29/32, H01L 29/20, H01L 29/417

(54) **High electron mobility transistor**

(30) Priority: 23.12.2009 FR 0906285
(71) Applicant: Thales, 92200 Neuilly Sur Seine (FR); Alcatel Lucent, 75008 Paris (FR)
(72) Inventor: Morvan, Erwan, 91530, SAINT CHERON (FR); Delage, Sylvain, 91400, ORSAY (FR)
(74) Representative: Bréda, Jean-Marc

(57) **Abstract**

High-electron-mobility field-effect transistor (100, 105, 110) comprising a multilayer stack, fabricated in a z-direction, comprising a substrate (3) on which is arranged a semiconductor bar (2) comprising a buffer layer (8), an active layer (7) and a heterojunction (15) that extends continuously in an xy-plane perpendicular to the z-direction, the transistor comprising electrodes (4, 5, 6) deposited on the side (20) of the semiconductor bar opposite the substrate (3), called the top side (20), the electrodes (4, 5, 6) extending longitudinally in a longitudinal y-direction and being spaced out in a transverse x-direction orthogonal to the y-direction so that a gate (6) is placed between a source (4) and a drain (5) adjacent to said source (4), the semiconductor bar (2) comprising at least one elementary region (ei), said elementary region (ei) being a region extending continuously in the transverse direction from a source (4) as far as a drain (5) adjacent to said source (4), which source and drain extend along their entire length over said elementary region (ei), in which region at least one isolating well (19) and at least one conductive region (18) extend continuously, over the whole transverse dimension of the elementary region (ei).

## Description

The present invention relates to high-electron-mobility field-effect transistors (HEMTs). A HEMT conventionally comprises a multilayer stack comprising a high-resistivity substrate, i.e. an insulator or semiconductor (for example made of SiC, Si or sapphire) on which is placed a semiconductor bar comprising a heterojunction. The term "heterojunction" is understood to mean a junction between two semiconductor layers having different chemical natures and which often having different bandgaps. The present invention relates more particularly to power HEMTs delivering a power of between 0.5 and 20 W/mm and HEMTs operating in the microwave range (from 1 GHz to 20 GHz). HEMTs are used in power amplification and in power switching.

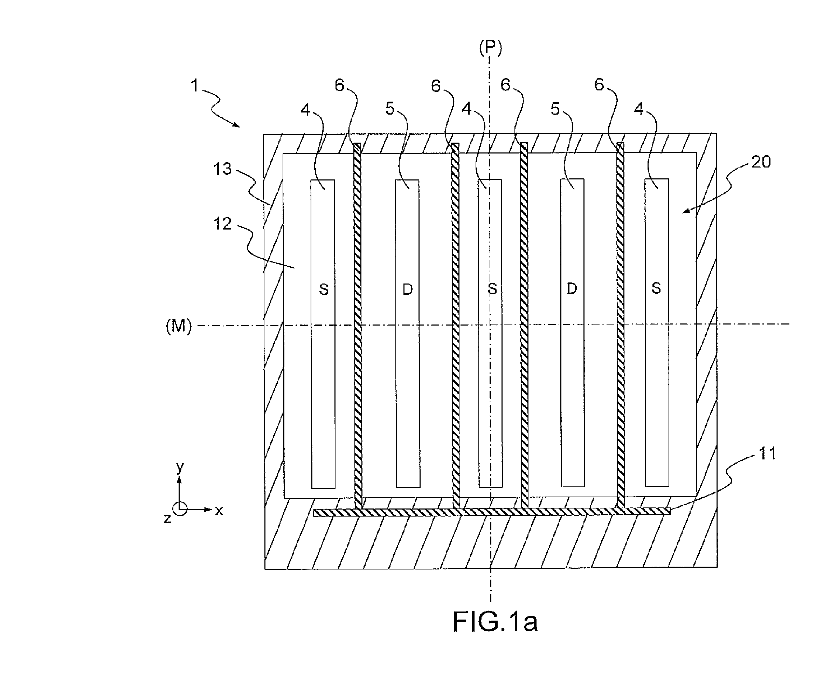

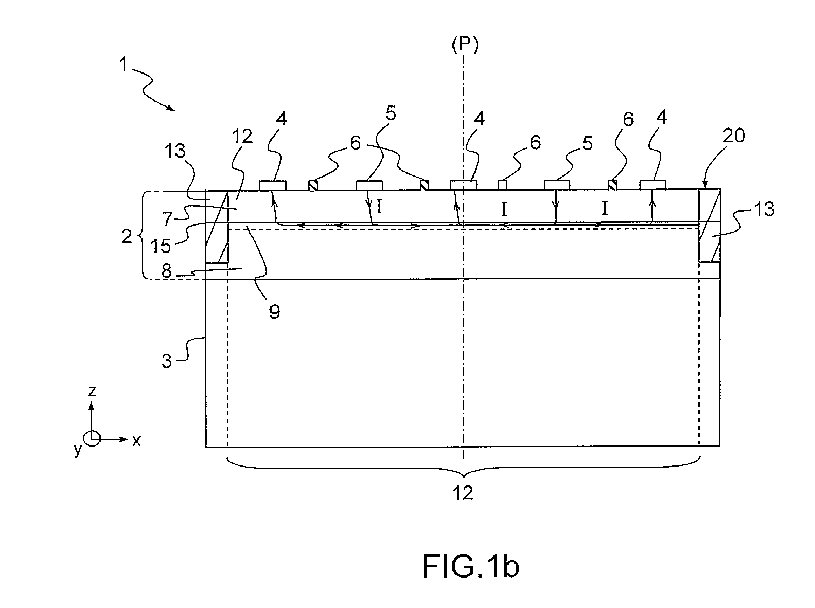

Figure 1a shows a top view of a conventional HEMT. Figure 1b shows a cross section of the transistor of Figure 1a in a transverse plan M, i.e. one defined by the orthogonal z- and x- directions. As may be seen in Figure 1b, the transistor conventionally comprises a multilayer stack of various materials in a z-direction. More precisely, it comprises a semiconductor bar 2 placed on a substrate 3. The semiconductor bar 2 comprises a layer 8 of a first semiconductor having a wide bandgap, called a buffer layer 8, and an active layer 7 made of a second semiconductor having a wider bandgap than the buffer layer 8.

The junction between the buffer layer 8 and the active layer 7 is a heterojunction 15. The heterojunction 15 conventionally extends continuously in the xy-plane. In the following, the x-direction will be called the transverse direction and the y-direction, perpendicular to the x- and z- directions, the longitudinal direction.

A HEMT conventionally comprises electrodes 4, 5, 6, comprising ohmic contacts 4, 5 and at least one gate 6, which are deposited on the top side 20 of the semiconductor bar 2. The top side 20 of the semiconductor bar is the surface of the bar opposite the substrate 3 in the z-direction. The electrodes extend longitudinally in the y-direction and are spaced out in the x-direction. The HEMT comprises in succession, in the x-direction, an ohmic contact and a gate 6, a gate being placed between two consecutive ohmic contacts comprising a source S, 4 and a drain D, 5 called adjacent drain and adjacent source because they are separated only by a gate and not by an ohmic contact. The ohmic contacts comprise a metal contact laid out on the side 20 and optionally one or more metal layers placed on the contact metal to improve the removal of heat generated within the semiconductor bar. The conductance between a source electrode S, 4 and a drain electrode D, 5 that are adjacent is conventionally modulated through the electrostatic action of the gate 6 which is conventionally a Schottky contact and which acts as a control electrode. The gates 6 are connected to a gate control pad 11 deposited on the top side 20, which pad extends longitudinally in the x-direction.

HEMTs are known that have a semiconductor bar 2 comprising an active central region 12 that receives entirely the ohmic contacts 4, 5 that are continuous in the y-direction, said central region 12 being surrounded by an isolating peripheral region 13 (shown by the hatching). The ohmic contacts are placed on the central region 12 and do not extend beyond this region. The gates extend continuously in the y-direction above the central region 12 and furthermore above the isolating peripheral region. In the example shown in Figure 1a, both ends of the gates extend above the isolating peripheral region.

The active central region 12 is the region of the transistor within which a current can flow. In known HEMTs, this region is commonly electrically conductive (over the entire area of the heterojunction). The electrically isolating peripheral region 13 isolates the central region 12 from optional elements located beyond the isolating peripheral region 13. The isolating region 13 forms a border around the central region 12. The semiconductor bar has, in the conducting central region 12, next to the heterojunction, a two-dimensional electron gas 9 (bounded by the heterojunction and the dotted lines in Figure 1b), the electrons being able to flow in the xy-plane and not able to flow in the z-direction because they are located in a potential well in the z-direction. The gas 9 is able to carry a current I in the xy-plane that flows between two consecutive ohmic contacts. The portions of the buffer layer 8 and active layer 7 located in the central region 12 have a substantially pure crystal structure (i.e. having a dislocation density of 10⁹/cm² or less) and optionally a substantially pure chemical composition (i.e. having a bulk impurity density of 10¹⁷/cm³ or less). The layers are epitaxial layers because the crystals of each layer have common symmetries.

The electrical insulation region 13 of the transistor contains no mobile electrons and it is thus insulating. This region is conventionally obtained by implanting ions at the periphery of the active central region. The ion implantation creates crystal defects within the semiconductor bar from its top side 20 down to within the buffer layer 8. It is also possible to obtain the electrically isolating region 13 by etching, i.e. removing, in this region, a part of the semiconductor bar that extends from the top side down to at least within the buffer layer 8.

When a current flows in the transistor, the semiconductor bar is subjected to a very-high electric field in certain places in the current-flow circuit, i.e. in the heterojunction and, to a lesser extent, in the ohmic contacts. The combination of the high current and local electric fields causes the transistor to heat up - the greater the power delivered by the transistor, the hotter the transistor. At conventional power densities and with the integration densities current in this technology, it becomes difficult to remove the heat generated. To ensure the correct operation of transistors, it is necessary to keep the active part of the transistor at a sufficiently low temperature. This is because the temperature increase in the semiconductor bar impairs the performance of the transistor and accelerates its ageing.

The aim of the present invention is to provide a transistor from which the heat is better removed and that costs a similar amount to a transistor of the prior art.

For this purpose, one subject of the invention is a high-electron-mobility field-effect transistor comprising a multilayer stack, fabricated in a z-direction, comprising a substrate on which is arranged a semiconductor bar comprising a buffer layer, an active layer and a heterojunction that extends continuously in an xy-plane perpendicular to the z-direction, the transistor comprising electrodes deposited on the side of the semiconductor bar opposite the substrate, called the top side, the electrodes extending longitudinally in a longitudinal y-direction and being spaced out in a transverse x-direction orthogonal to the y-direction so that a gate is placed between a source and a drain adjacent to said source, in which the semiconductor bar comprises at least one elementary region, an elementary region being a region extending continuously in the transverse direction from a source as far as a drain adjacent to said source, which source and drain extend along their entire length over said elementary region, in which region at least one isolating well and at least one conductive region extend continuously, over the whole transverse dimension of the elementary region.

The transistor according to the invention may have the following features, singly or in combination:
- it comprises a plurality of elementary regions;
- at least one isolating well extends continuously in the transverse direction over a plurality of elementary regions;
- the isolating wells in the central region of the transistor have, in an xy-plane, a surface area greater than that of the isolating wells in the peripheral region of the transistor;
- the isolating wells in the central region of the transistor have a longitudinal dimension greater than that of the isolating wells in the peripheral region of the transistor;
- it comprises at least one isolating well having a variable longitudinal dimension which is greater in the central region of the transistor than in the peripheral region of the transistor;
- at least some of the isolating wells of the transistor are distributed in bands extending in the transverse direction over all the elementary regions;
- at least some of the isolating wells are distributed in a checkerboard arrangement in an xy-plane;
- the isolating wells of the checkerboard arrangement in the central region of the transistor have a transverse dimension greater than that of the isolating wells in the peripheral region;
- the isolating well extend in the z-direction, from the surface of the semiconductor bar opposite the substrate and at least down to within the buffer layer;
- the portions of the buffer and active layers located within the electrically conductive regions are substantially perfect crystals and the portions of the buffer and active layers located within said isolating wells and in the isolating peripheral region contain crystal defects;
- the active layer is fabricated from a ternary or binary Group-III-element nitride and the buffer layer is fabricated from a binary Group-III-element nitride; and
- the elementary region or regions lie within an active central region that receives said electrodes of which the source (or sources) and drain (or drains) extend along their entire length over the active central region, said active central region being surrounded by an isolating peripheral region.

Another subject of the invention is a process for fabricating a high-electron-mobility field-effect transistor according to the invention, comprising the following steps: A) fabricating, by epitaxial growth in the z-direction, a multilayer stack comprising a substrate on which is arranged a semiconductor bar comprising a buffer layer, an active layer and a heterojunction that extend continuously in the xy-plane; B) depositing a mask on the top side of the semiconductor bar, the mask being arranged so as to cover in the elementary region (or regions) only the areas intended to remain conducting; and C) fabricating the isolating well (or wells) by ion implantation. The step of fabricating the isolating well (or wells) may furthermore be a step of fabricating the isolating peripheral region.

The divided transistor comprises, in the x-direction, a succession of divided elementary transistors and, in the y-direction, in alternation, elementary active portions, which are heat sources contributing to the increase in the local temperature, and elementary inactive portions in which the heat, produced by the adjacent elementary active portions, is dissipated. The division allows the area distribution of the elementary active portions (heat sources) to be optimized in order to operate each elementary transistor under the best temperature, frequency, power density, yield, PAE (power added efficiency) and reliability conditions possible.

The division allows maximum performance to be obtained from the semiconductor bar. It allows a good compromise to be obtained between the local power density and the temperature of the transistor. The best compromise is obtained for a transistor in which the power density is maximized, in the elementary active portions, and in which the temperature is minimized. The division enables, for the same internal temperature, the local power density to be increased in the transistor according to the invention relative to that of a transistor of the prior art. It is thus possible to reduce the size of the active central region of the transistor, thereby allowing its impedance to be increased and improving impedance matching in the circuits. At maximum power density, an undivided transistor, in which all the elementary active portions are adjacent, results in a high concentration of heat sources and therefore in a high temperature in the active regions (impairing the performance and reliability of the transistor).

Other features and advantages of the invention will become clear on reading the following detailed description given by way of non-limiting example and with reference to the appended drawings in which:
- Figure 1 a and Figure 1b, already described, respectively show a schematic top view of a conventional HEMT and a cross section of the transistor of Figure 1a in a transverse plane M;
- Figure 2 shows schematically, from above, a first example of a high-electron-mobility transistor according to a first embodiment of the invention;
- Figure 3 shows schematically a cross section of the prior-art transistor in a longitudinal plane P extending along a source electrode 4;
- Figure 4 shows schematically a cross section, in a longitudinal plane P', of the transistor according to the invention shown in Figure 2, the plane P' extending along a source electrode 4;
- Figure 5 shows schematically, from above, a second example of a high-electron-mobility transistor according to the first embodiment of the invention; and
- Figures 6a and 6b, show schematically a second embodiment of the transistor according to the invention, respectively from above and in cross section in a transverse plane M".

From one figure to another the same elements are denoted by the same references.

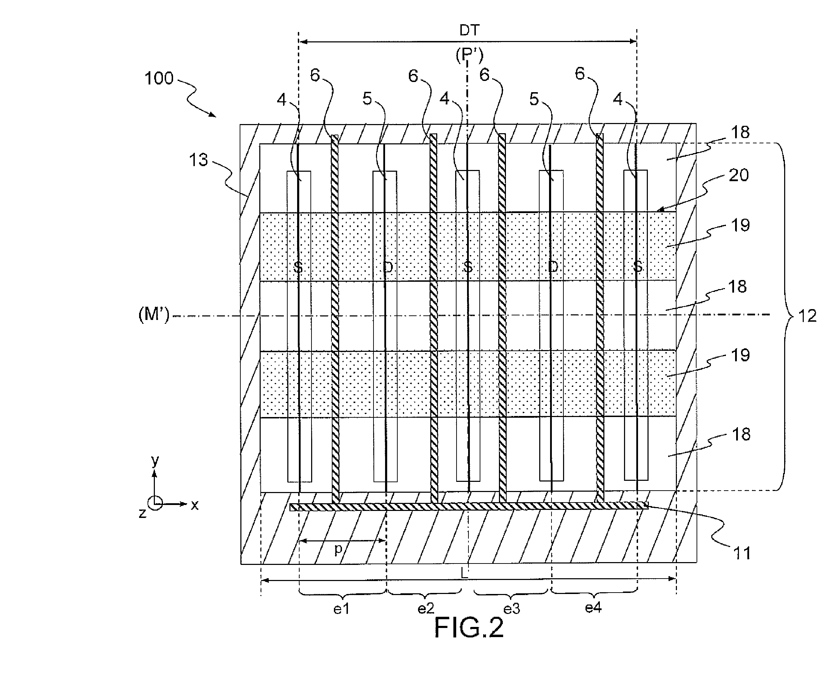

A schematic top view of a high-electron-mobility transistor 100 according to a first embodiment of the invention is shown in Figure 2. Elements that are identical to those shown in Figure 1 a are denoted by the same reference numbers and will not be described again. The transistor comprises the same structure as the prior-art transistor shown in Figures 1a and 1 b except in the insulating wells 19, which will be described subsequently. In a transverse plane M', extending into the active central region 12, along a conductive band 18, the transistor according to the first embodiment has an identical structure to that of the transistor shown in Figure 1 b.

A transistor according to the invention comprises a multilayer stack comprising a substrate 3 and a semiconductor bar 2 comprising a buffer layer 8 and an active layer 7. The isolating substrate is preferably made from an electrically insulating material having a thermal conductivity of at least 100 W/m.K. The material may be chosen from silicon carbide SiC, silicon Si and aluminium oxide Al₂O₃. For power switching, the substrate may be made of an insulator or semiconductor. The first semiconductor material forming the buffer layer 8 is a binary Group-lll-element nitride, for example GaN. The second semiconductor material forming the active layer 7 is a ternary Group-III-element nitride or a binary Group-III-element nitride. It is, for example, AlGaN, InGaN, lnAlN or AIN (where Al is aluminium and In is indium). As a variant, the semiconductor bar is based on GaAs. For example, the buffer layer is made of GaAs and the active layer is made of lnGaAs.

Nitride-based transistors have a higher power density than materials like GaAs. Their power density is between 3 and 20 W/mm in the two-dimensional electron gas. They are furthermore power transistors operating in the microwave range. The buffer layer 8 preferably has a thickness of between 1 and 5 µm. The active layer 7 preferably has a thickness of between 5 and 30 nm.

The buffer layer 8 and the active layer 7 are optionally joined via a spacer layer (not shown) having a thickness of 2 nm or less and the function of which is to improve the mobility of the electrons in the electron gas. A protection layer having a thickness of between 2 and 300 nm may be placed on the active layer 7 so as to protect the semiconductor bar from the external environment. A spacer layer may also be placed between the buffer layer 8 and the substrate 3 to aid the epitaxial growth.

The pitch p, namely the distance between adjacent sources and drains is preferably between 30 and 100 µm, corresponding to a compromise between the integration density and the heat density generated within the transistor. The integration density is inversely proportional to the pitch. The pitch corresponds to the dimension of an elementary transistor that will be subsequently defined, in the transverse x-direction. In the following, the transverse dimension and the longitudinal dimension of an object will be called the dimension of the object in the transverse direction and in the longitudinal direction, respectively.

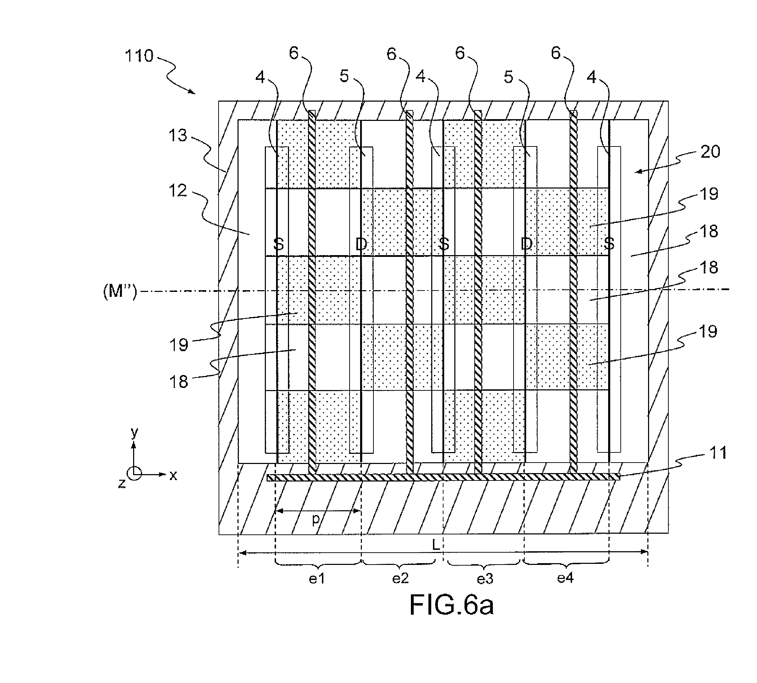

A transistor according to the invention comprises at least one elementary region ei that extends continuously in the transverse direction from a source 4 as far as a drain 5 adjacent to said source 4, said source 4 and said drain 5 adjacent to the source extending along their entire length over said elementary region ei, in which region isolating wells 19 (shown as dotted regions in Figures 2, 4, 5a, 5b) and conductive regions 18 (shown by adjoining white regions in Figures 2, 4, 5a and 5b) extend continuously, over the whole transverse dimension p of the elementary zone ei. For greater clarity, all the conductive regions and isolating wells in Figure 6a are not numbered. Also, i = 1,...n, where n is equal to the number of gates in the transistor.

In other words, the elementary regions ei comprise, in the y-direction, an alternation of isolating regions 19 and conductive regions 18 which each extend continuously between a source and an adjacent drain. The isolating wells 19 and the conductive regions extend continuously in the transverse direction over one or more adjacent regions. The portions of the buffer layer 8 and of the active layer 7 located in the conductive regions 18 have a substantially pure crystal structure. The electrons in the semiconductor bar 2 located next to the heterojunction 15 lying within a conductive region are localized in a conduction band. These electrons can flow in the conduction band - they form a two-dimensional electron gas 9.

The wells 19 are regions extending, in the z-direction, from the top side 20 of the semiconductor bar 2 and at least down to with the buffer layer 8. The isolating wells 19 have, for example, a quadrilateral cross section in the xy-plane, for example a rectangular cross section as in Figure 2.

In the example shown in Figure 2, the transistor according to the invention comprises a plurality of elementary regions e1, e2, e3, e4 bounded by the thick lines extending in the y-direction and by the limits of the active central region in the x-direction. In the rest of the text, the unit formed by an elementary region and the adjacent gate portions and ohmic contacts 4, 5 that the elementary region receives is called an elementary transistor. The elementary regions together form a unit having a unit transverse dimension DT that corresponds to the sum of the transverse dimensions of the elementary regions.

In Figure 2, the elementary regions are contiguous. They are not spaced apart in the x-direction. As a variant, the transistor comprises distinct elementary regions that are spaced apart in the x-direction. Two distinct elementary regions are separated, beneath the common ohmic contact, by a conductive region that extends along the entire length of this ohmic contact.

In the example of a transistor according to a first embodiment of the invention, shown in Figure 2, the isolating wells 19 of the transistor are distributed in bands that extend transversely over the whole of the elementary regions, i.e. the bands extend longitudinally in the transverse direction. In other words, said bands extend continuously in the transverse direction over the whole of the transverse dimension of the unit DT. The same is also true for the conductive regions 18. In the example shown in Figure 2, the transistor comprises an active central region 12, comprising the wells 19 and the conductive regions 98, which region 12 is surrounded on its periphery (in an xy-plane) by an isolating peripheral region 13. The isolating wells 19 and the conductive regions 18 extend continuously in the transverse direction over the whole of the transverse dimension L of the central region 12.

In the embodiment shown in Figure 2, the bands formed by the conductive regions 18 have the same area in the xy-plane. The same is true for the bands formed by the isolating wells 19. They furthermore have a rectangular cross section in the xy-plane.

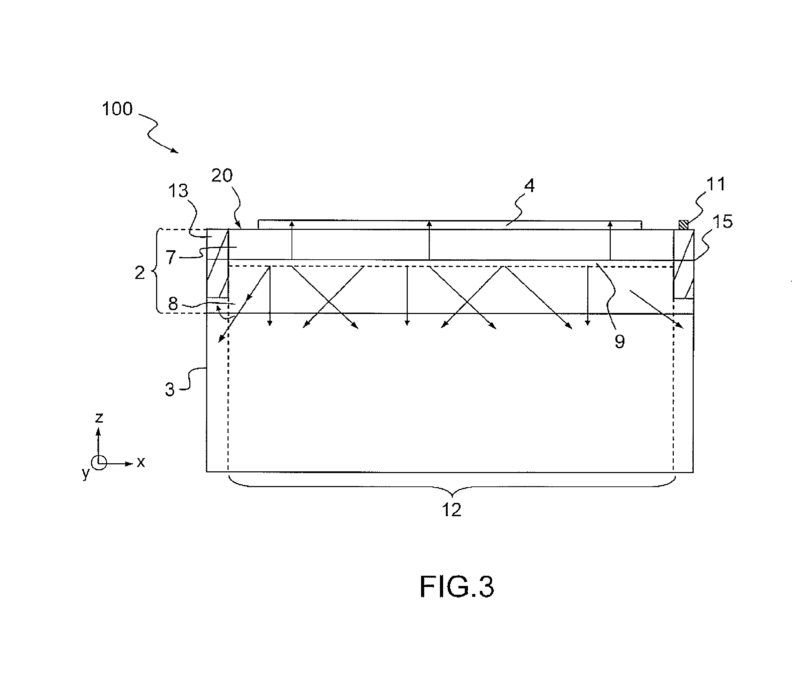

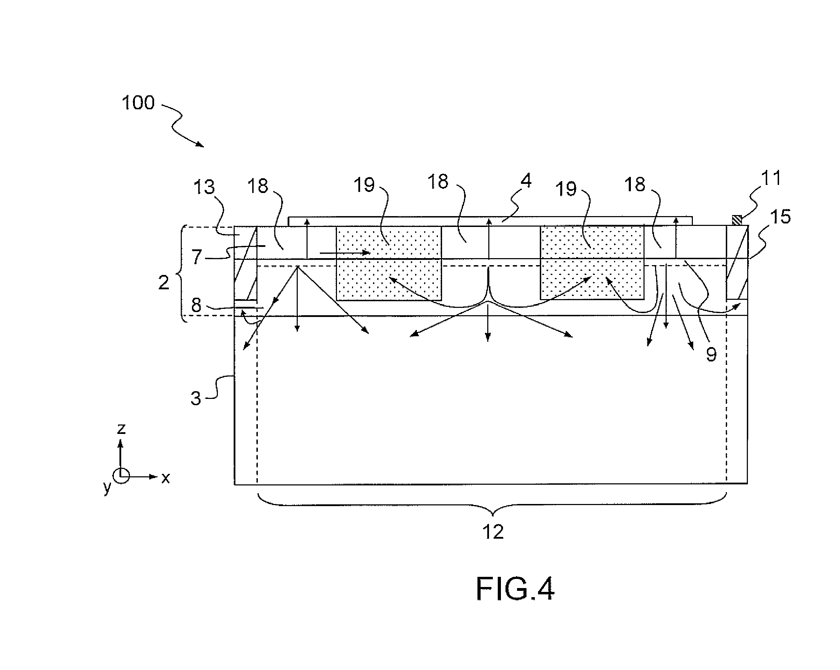

Shown schematically in Figures 3 and 4, respectively, are a cross section of the transistor shown in Figures 1a and 1b in a longitudinal plane P, and a cross section of the transistor shown in Figure 2 in a longitudinal plane P'. The heat flow within the transistor is shown by arrows in these two figures.

In Figure 1a, the active central region 12 is continuously conductive over its entire area. The central region may be considered to comprise a plurality of elementary transistors that are contiguous in the x-direction and continuously active in the y-direction and each elementary transistor may be considered to comprise, in the y-direction, contiguous elementary active portions in succession. In Figure 3, this is embodied by a continuous conductive central region along the source 4. The source of electrical power, which is also the heat source, is located at the heterojunction 15 that also extends over the entire length of the source 4. The heat is dissipated from the heterojunction towards the substrate, the electrodes and in the adjacent elementary active portions and in the isolating region 13.

In Figure 4, it is seen that beneath the electrode 4 the active central region 12 comprises, in alternation along the y-direction, conductive regions 18 and isolating wells 19. The central region therefore comprises a plurality of discrete power and heat sources separated from one another by isolating wells 19. In other words, each elementary transistor comprises an alternation, in the y-direction, of elementary active portions and elementary inactive portions.

The expression "isolating well" is understood to mean a region of the semiconductor bar having a resistivity greater than or equal to 10⁷ ohms.cm. In an isolating well 19, the semiconductor bar 2 has no electron gas. It is a region which comprises, in the z-direction, stabilized crystal defects in a sufficient amount that the two-dimensional electron gas is neutralized. The defects are present from the top side 20 of the bar 2 down to at least within the buffer layer 8. The crystal defects modify the electrical activity of the bar 2. They create deep electronic levels in the bandgap of the layers 7, 8. Thus, the electrons of the semiconductor bar 2 located next to the heterojunction 15 in the isolating wells are trapped in the deep electronic levels and are no longer able to move through the volume and therefore in the xy-plane. The power sources within the transistor and within the elementary transistors are diluted. The heat produced by a conductive region 18 is dissipated both in the substrate 3 and in the electrodes, but also in the isolating wells 19 and in the rest of the semiconductor bar. The temperature of each elementary transistor is therefore lower and its performance is not impaired. The temperature uniformity within the transistor is also improved.

Simply introducing defects into the region that receives the electrodes allows, for a given local power density and given dimensions, the internal temperature of the transistor to be reduced. The expression "local power density" is understood to mean the power density within the conductive regions 18. Thus, the electrical performance (linked to the thermal performance), the lifetime of the HEMT and the reliability of an optional integrated circuit are improved. The dimensions of the transistor according to the invention are unchanged relative to those of actual transistors and they have a similar cost. Moreover, the electrodes of a transistor according to the invention are unchanged relative to those of a transistor of the prior art, thereby aiding the removal of heat produced by the transistor. This is because the electrodes are thick metal regions through which the heat produced by the electron gas 9 is removed. A smaller amount of heat than in the prior art must therefore be removed in the same amount of metal.

Counterintuitively, the Applicant has furthermore observed that the microwave behaviour of the transistor according to the invention is unchanged, for an identical local power density, relative to the behaviour of prior-art transistors the active central region 12 of which have the same cross section in the xy-plane as the group of conductive regions 18 of the transistor of the invention.

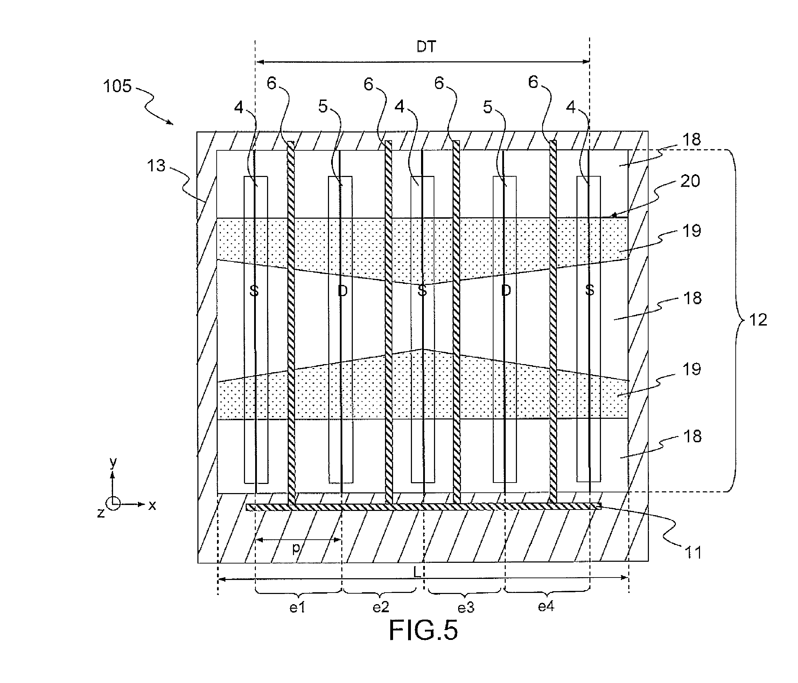

Figure 5 shows a second example of the transistor 105 according to the first embodiment of the invention. In this example, the transistor comprises isolating wells 19 having a longitudinal dimension that is larger in the central region of the transistor than at the periphery of the transistor (i.e. the periphery of the active central region 12). The heat distribution is even more uniform than in the first example shown in Figure 2. This is because the edge effects of the transistor are taken into account. At the edge of the transistor, the heat-generating conductive regions 18 are adjacent to the isolating peripheral region 13 into which heat may be dissipated. In contrast, in the central region, the conductive regions 18 dissipate heat into the adjacent isolating wells 19. Moreover, this is all the more true when the longitudinal dimensions of the conductive regions 18 are smaller than those of the embodiment in Figure 2. In Figure 5, the longitudinal dimension of the isolating wells 19 is a linear function of the distance from the centre of the transistor in the transverse x-direction. This function may be different, for example logarithmic. The longitudinal dimension of the isolating wells may also depend on the distance from the centre of the transistor in the y-direction.

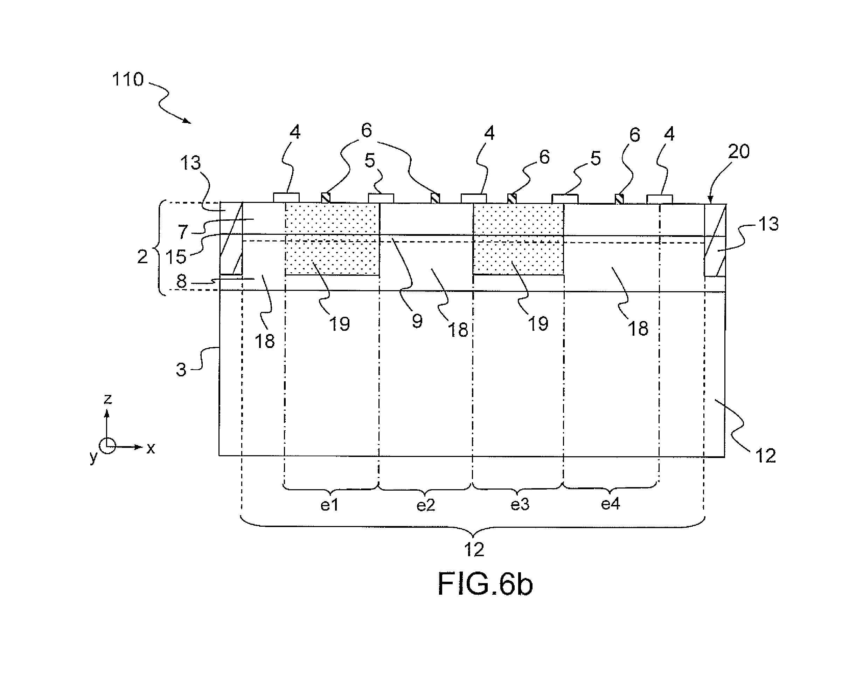

Schematics of an example of a second embodiment of the transistor 110 are shown from above in Figure 6a and in cross section, along a transverse plane M", in Figure 6b,. In this second embodiment, the isolating wells 19 are distributed in a checkerboard arrangement in the xy-plane. Two consecutive wells 19, along the x-direction and y-direction respectively, are separated by a conductive region 18. In this example, the isolating wells extend transversely over a single elementary region. As a variant, the checkerboard arrangement may comprise at least one isolating well 19 that extends continuously over a plurality of elementary regions. The cross section of the isolating wells in the xy-plane take the form of a quadrilateral, two sides of which extend generally in the y-direction. The term "generally" is understood to mean that the sides of the checkerboard squares may be curved. In this example, the wells of the central region of the transistor have an identical cross section in the xy-plane, whereas the wells further removed from the centre of the transistor in the y-direction have a larger cross-sectional area.

As a variant, to improve the heat distribution within the transistor, relative to the example in Figure 6a, a different, irregular checkerboard arrangement is fabricated in which the isolating wells in the central region have a cross-sectional area greater than the wells at the periphery of the transistor. Advantageously, the isolating wells 19 in the peripheral region of the transistor have a longitudinal dimension and/or a transverse dimension that is smaller than those in the central region of the transistor. Advantageously, an isolating well has a longitudinal dimension that is larger at the centre of the transistor than at the periphery of the transistor. As a variant, a regular checkerboard arrangement is fabricated in which all the isolating wells have an identically dimensioned cross section in the xy-plane.

In the example shown in Figures 6a and 6b, the wells joined by a vertical stop. In practice, the isolating wells may be distinct i.e. they are spaced apart in the x-direction and/or the y-direction. This is for example the case when the elementary regions ei are distinct.

The subject of the invention is also a process for fabricating a transistor 100, 110, 120 according to the invention. The process advantageously comprises the following steps:
- fabricating, by epitaxial growth in the z-direction, a multilayer stack comprising a substrate 3 on which is arranged a semiconductor bar 2 comprising a buffer layer 8 and an active layer 7 and a heterojunction 15 extending continuously in the xy-plane, perpendicular to the z-direction;
- depositing a mask on the top side of the semiconductor bar 2, the mask being arranged so as to cover in the elementary region (or regions) (ei) only the regions intended to remain conducting regions 18; and
- fabricating the isolating well (or wells) 19 by ion implantation.

When the multilayer stack comprising the substrate and the semiconductor bar 2 is fabricated epitaxially, the buffer and active layers have a substantially perfect crystal structure. Thus, the bar is conductive. The implantation step is intended to create isolating wells in the semiconductor bar. The mask is arranged so that the regions provided with the mask coincide with the conductive regions 18 described above and the regions with no mask coincide with the isolating wells 19 described above. The mask is conventionally made of an appropriate resist so as to protect the regions intended to remain conducting after the implantation step. The mask is conventionally produced using photolithography. The ion implantation step is performed in a manner known to those skilled in the art; it comprises a step of bombarding the top surface of the semiconductor with ions, for example noble-gas ions such as helium ions He⁺ or argon ions Ar⁺. The noble-gas ions have the advantage of not chemically modifying the materials into which they are implanted.

The greater the number of ions sent to the surface of the transistor and the higher the kinetic energy with which they arrive at the surface, the greater the depth of the implantation and the greater the number of defects created in these layers. The number of ions sent to the surface of the transistor and the kinetic energy with which they arrive at the surface of the bar are chosen so as to suppress the two-dimensional electron gas, i.e. so as to make the transistor insulating in this region.

For example, in the process according to the invention, between 10¹² and 10¹⁴ ions per square centimetre are sent to the surface of the bar 2, with an energy of between 20 keV and 190 keV, so as to create, in the regions with no mask, between 10¹⁸ and 10²³ defects per cm³ in the bar 2 from the surface down to within the buffer layer 8. The thickness is preferably 1 µm or less, that is to say over a thickness of between 0.5 and 1 µm. The implanted regions, or isolating wells, being thus superficial, the cone of heat dissipation from the conductive regions is not hindered by the implanted regions which have a slightly reduced thermal conductivity relative to the unimplanted regions of the bar 2.

The implantation step then comprises a step of stripping the resist, i.e. a step of removing the mask defining the ion implantation region (or regions). It optionally comprises a high-temperature stabilisation annealing step, for example at 400°C. The process advantageously comprises a step of depositing electrodes 4, 5, 6 on the top surface 20 of the semiconductor bar 2.

Preferably, the mask is furthermore arranged so that the region intended to form the isolating peripheral region 13 has no mask. Thus, the isolating wells are fabricated at the same time as the isolating peripheral region 13 of the transistor as regards external elements.

The process of the invention is simple to implement - it does not require additional steps relative to the process for fabricating a transistor of the prior art. As a variant, the isolating peripheral region is produced by etching, but this technology is not planar. The shape and arrangement of the conductive and non-conductive regions in the xy-plane is very flexible because they depend only on the shape and arrangement of the masks used. The ion implantation technique is very simple to implement, of benefit in terms of the fabrication yield of the transistor.

## Claims

1. Higia-electron-mobility field-effect transistor (100, 105, 110) comprising a multilayer stack, fabricated in a z-direction, comprising a substrate (3) on which is arranged a semiconductor bar (2) comprising a buffer layer (8), an active layer (7) and a heterojunction (15) that extends continuously in an xy-plane perpendicular to the z-direction, the transistor comprising electrodes (4, 5, 6) deposited on the side (20) of the semiconductor bar opposite the substrate (3), called the top side (20), the electrodes (4, 5, 6) extending longitudinally in a longitudinal y-direction and being spaced out in a transverse x-direction orthogonal to the y-direction so that a gate (6) is placed between a source (4) and a drain (5) adjacent to said source (4), **characterized in that** the semiconductor bar (2) comprises at least one elementary region (ei), an elementary region (ei) being a region extending continuously in the transverse direction from a source (4) as far as a drain (5) adjacent to said source (4), which source and drain extend along their entire length over said elementary region (ei), in which region isolating wells (19) and at least one conductive region (18) extend continuously, over the whole transverse dimension of the elementary region (ei), an isolating well (19) in the central region of the transistor having, in an xy-plane, a surface area greater than that of an isolating well (19) in the peripheral region of the transistor.

2. Transistor according to the preceding claim, **characterized in that** an isolating well (19) in the central region of the transistor have a longitudinal dimension greater than that of an isolating well (19) in the peripheral region of the transistor.

3. High-electron-mobility field-effect transistor (100, 105, 110) comprising a multilayer stack, fabricated in a z-direction, comprising a substrate (3) on which is arranged a semiconductor bar (2) comprising a buffer layer (8), an active layer (7) and a heterojunction (15) that extends continuously in an xy-plane perpendicular to the z-direction, the transistor comprising electrodes (4, 5, 6) deposited on the side (20) of the semiconductor bar opposite the substrate (3), called the top side (20), the electrodes (4, 5, 6) extending longitudinally in a longitudinal y-direction and being spaced out in a transverse x-direction orthogonal to the y-direction so that a gate (6) is placed between a source (4) and a drain (5) adjacent to said source (4), **characterized in that** the semiconductor bar (2) comprises at least one elementary region (ei), an elementary region (ei) being a region extending continuously in the transverse direction from a source (4) as far as a drain (5) adjacent to said source (4), which source and drain extend along their entire length over said elementary region (ei), in which region at least one isolating well (19) and at least one conducting region (18) extend continuously, over the whole transverse dimension of the elementary region (ei), at least one isolating well (19) having a variable longitudinal dimension which is greater in the central region of the transistor than in the peripheral region of the transistor.

4. Transistor according to any one of the preceding claims, **characterized in that** it comprises a plurality of elementary regions (ei)

5. Transistor according to the preceding claim, **characterized in that** at least one isolating well (19) extends continuously in the transverse direction over a plurality of elementary regions (ei).

6. Transistor according to the preceding claim, **characterized in that** it comprises a plurality of isolating wells and **in that** at least some of the isolating wells (19) of the transistor are distributed in bands extending in the transverse direction over all the elementary regions.

7. Transistor according to any one of Claims 4 to 6, **characterized in that** it comprises a plurality of isolating wells and **in that** at least some of the isolating wells (19) are distributed in a checkerboard arrangement in an xy-plane.

8. Transistor according to the preceding claim, **characterized in that** the isolating wells (19) of the checkerboard arrangement in the central region of the transistor have a transverse dimension greater than that of the isolating wells (19) in the peripheral region.

9. Transistor according to any one of the preceding claims, **characterized in that** said each isolating well (19) extend in the z-direction, from the top side (20) of the semiconductor bar and at least down to within the buffer layer (8).

10. Transistor according to any one of the preceding claims, **characterized in that** the portions of the buffer layer (8) and active layer (7) located within the conducting regions (18) are substantially perfect crystals and **in that** the portions of the buffer layer (8) and active layer (7) located within each isolating well (19) and in an isolating peripheral region (13) contain crystal defects.

11. Transistor according to any one of the preceding claims, **characterized in that** the active layer (7) is fabricated from a ternary or binary Group-III-element nitride and **in that** the buffer layer (8) is fabricated from a binary Group-III-element nitride.

12. Transistor according to any one of the preceding claims, **characterized in that** said at least one elementary region lies within an active central region (12) that receives said electrodes (4, 5, 6) of which at least one source (4) and at least one drain (5) extend along their entire length in the active central region (12), said active central region (12) being surrounded by an isolating peripheral region (13).

13. Process for fabricating a high-electron-mobility field-effect transistor (100, 105, 110) according to any one of the preceding claims, comprising the following steps:
- fabricating, by epitaxial growth in the z-direction, a multilayer stack comprising the substrate (3) on which is arranged the semiconductor bar (2) comprising the buffer layer (8), the active layer (7) and the heterojunction (15) extending continuously in the xy-plane;
- depositing a mask on the top side (20) of the semiconductor bar (2), the mask being arranged so as to cover in said at least one elementary region (ei) only the regions intended to remain conducting regions (18); and
- fabricating at least one isolating well (19) by ion implantation.

14. Process according to the preceding claim (in that it depends on Claim 13), **characterized in that** the step of fabricating at least one isolating well (19) is furthermore a step of fabricating the isolating peripheral region (13).
